# EUROPEAN PATENT APPLICATION

(11) **EP 2 752 887 A1**
(43) Date of publication of application: **09.07.2014**
(21) Application number: 11871746.1
(22) Date of filing: 31.08.2011
(51) Int. Cl.: H01L 31/042

(54) **METHOD FOR PRODUCING SOLAR CELL MODULE**

(71) Applicant: Sanyo Electric Co., Ltd., Osaka 570-8677 (JP)
(72) Inventor: YOSHIMINE, Yukihiro, Moriguchi-shi Osaka 570-8677 (JP)
(74) Representative: Glawe, Delfs, Moll
(86) International application number: PCT/JP2011/069803
(87) International publication number: WO 2013/030992

(57) **Abstract**

Provided is a method for manufacturing a solar module in which it is possible to electrically connect a wiring member and a solar cell in an advantageous manner. A first connection step is performed in which a wiring member (2) is connected to a first electrode (11) arranged on the back surface of a first solar cell (1). The first connection step includes a step of arranging the wiring member (2) on the first electrode (11) with a resin adhesive (31) interposed therebetween, and a step of heating the wiring member (2) while applying relative pressure on the first electrode (11) side. The heating step is performed separately in a plurality of areas (A1-A4).

## Description

### FIELD OF THE INVENTION

The present invention relates to a manufacturing method for a solar module.

### BACKGROUND

Solar modules in which a plurality of solar cells is connected electrically have attracted much attention in recent years as an energy source with a low environmental impact. A solar module including back contact solar cells has been disclosed in Patent Document 1. In the solar module described in Patent Document 1, the wiring member has a plurality of wires, and the p-side electrode of one solar cell is connected electrically to the n-side electrode of an adjacent solar cell using said wires. Patent Document 1 describes the bonding of the wiring member to solar cells using anisotropically conductive film.

### Prior Art Documents

### Patent Documents

Patent Document 1: Laid-Open Patent Publication No. 2009-266848

### SUMMARY

### Problem Solved by the Invention

There is room for improving the method of adhering a solar cell to a wiring member described in Patent Document 1.

It is a main object of the present invention to provide a method for manufacturing a solar module in which it is possible to electrically connect a wiring member and a solar cell in an advantageous manner.

### Means of Solving the Problem

In the present invention, the method for manufacturing a solar module includes a first connection step. In the first connection step, a wiring member is connected to a first electrode arranged on the back surface of a first solar cell. The first connection step includes a step of arranging the wiring member on the first electrode with a resin adhesive interposed between them, and a step of heating the wiring member while applying relative pressure on the first electrode side. The heating step is performed separately in a plurality of areas.

### Effect of the Invention

The present invention is able to provide a method for manufacturing a solar module in which it is possible to electrically connect a wiring member and a solar cell in an advantageous manner.

### BRIEF DESCRIPTION OF THE DRAWINGS

FIG. 1 is a simplified rear view of a solar cell in a first embodiment.
FIG. 2 is a simplified rear view of a wiring member in the first embodiment.
FIG. 3 is a simplified rear view used to explain the manufacturing process for a solar module in the first embodiment.
FIG. 4 is a simplified cross-sectional view from line IV-IV in FIG. 3.
FIG. 5 is a simplified cross-sectional view used to explain the manufacturing process for a solar module in the first embodiment.
FIG. 6 is a simplified cross-sectional view of the solar module manufactured in the first embodiment.
FIG. 7 is a simplified cross-sectional view used to explain the manufacturing process for a solar module in a second embodiment.
FIG. 8 is a simplified cross-sectional view used to explain the manufacturing process for a solar module in the second embodiment.

### DETAILED DESCRIPTION

The following is an explanation of examples of preferred embodiments of the present invention. The following embodiments are merely examples. The present invention is not limited by the following embodiments in any way.

Further, in each of the drawings referenced in the embodiments, members having substantially the same function are denoted by the same symbols. The drawings referenced in the embodiments are also depicted schematically. The dimensional ratios of the objects depicted in the drawings may differ from those of the actual objects. The dimensional ratios of objects may also vary between drawings. The specific dimensional ratios of the objects should be determined with reference to the following explanation.

### 1 st Embodiment

### Step of Preparing Solar Cell 1 and Wiring Member 2

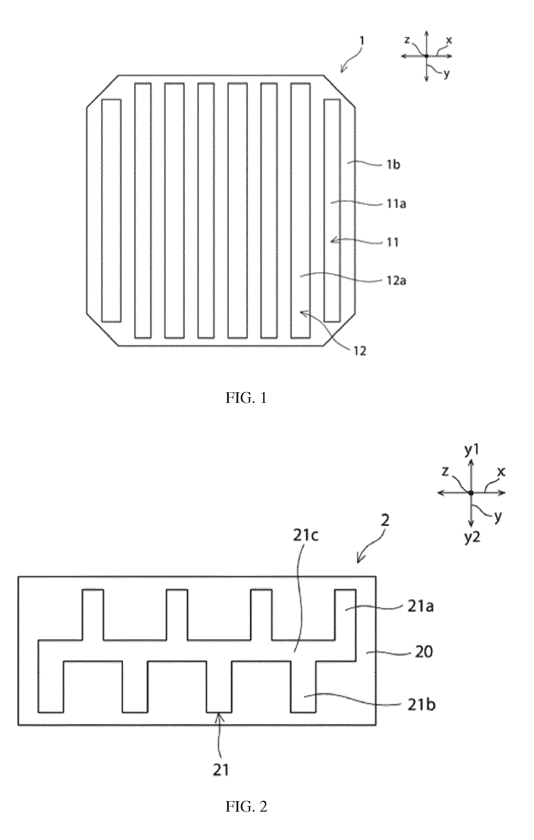

First, a plurality of the solar cells 1 shown in FIG. 1 and the wiring member 2 shown in FIG. 2 are prepared. There are no particular restrictions on the type of solar cell 1. The solar cells 1 can be made, for example, using any type of semiconductor material such as a crystalline semiconductor or a thin-film semiconductor.

The solar cells 1 are back contact solar cells. In other words, the solar cells 1 have a light-receiving surface (not shown) and a back surface 1b, and the back surface 1b has first and second electrodes 11 and 12. One of the first and second electrodes 11, 12 is an electrode that collects holes, and the other is an electrode that collects electrons.

The first electrode 11 has a plurality of first finger portions 11a. The second electrode 12 has a plurality of second finger portions 12a. More specifically, the first electrode 11 is a busbarless electrode that includes a plurality of first finger portions 11a but no busbar portion. The second electrode 12 is also a busbarless electrode that includes a plurality of second finger portions 12a but no busbar portion.

Each of the first finger portions 11a constituting the first electrode 11 extends in the y-direction, or the first direction, so as to be oriented from one end to the other in the y-direction. The first finger portions 11a are arranged at predetermined intervals in the x-direction, or the second direction, which intersects the y-direction. Each of the second finger portions 12a constituting the second electrode 12 extends in the y-direction, so as to be oriented from one end to the other in the y-direction. The second finger portions 12a are arranged at predetermined intervals in the x-direction. The first finger portions 11a and the second finger portions 12a are interdigitated in the x-direction.

The first and second electrodes 11, 12 can be made of a suitably conductive member. For example, the first and second electrodes 11, 12 can be made of a metal such as Ag, Cu, Au, Pt or Sn, or from an alloy including at least one of these metals. One or both of the first and second electrodes 11, 12 can be a stacked body composed of a plurality of conductive layers.

The wiring member 2 is used to electrically connect a plurality of solar cells 1. The wiring member 2 has a length in the x-direction that covers all of the first finger portions 11a. The wiring member 2 also has a length in the x-direction that covers all of the second finger portions 12a. The wiring member 2 has a wiring member main body 20 and wiring 21. There are no particular restrictions on the material used to form the wiring member main body as long as the material is an insulator. The wiring member main body 20, for example, can be made of a ceramic material or a resin material. The wiring member main body 20 is preferably made of a resin because it is easier to manufacture.

The wiring 21 is arranged on the wiring member main body 20. In the present invention, the entirety of the wiring does not have to be arranged on the wiring member main body. Some of the wiring may be arranged inside of the wiring member main body.

The wiring 21 can be made of a suitably conductive member. For example, the wiring 21 can be made of a metal such as Ag, Cu, Au, Pt or Sn, or from an alloy including at least one of these metals.

The wiring 21 has a plurality of first linear portions 21a, a plurality of second linear portions 21 b, and a connecting portion 21c. The first linear portions 21a and second linear portions 21b are connected electrically to the connecting portion 21c. Each of the first linear portions 21a extends in the y-direction from the connecting portion 21c towards the y1 side (the one side in the first direction). The first linear portions 21a are connected electrically to the first finger portions 11a of the solar cell 1, and are provided so as to correspond to the first finger portions 11a. In other words, the first linear portions 21a are arranged at intervals in the x-direction at the same pitch as the first finger portions 11a.

Each of the second linear portions 21b extends in the y-direction from the connecting portion 21c towards the y2 side (the other side in the first direction). The second linear portions 21b are connected electrically to the second finger portions 12a of the solar cell 1, and are provided so as to correspond to the second finger portions 12a. In other words, the second linear portions 21b are arranged at intervals in the x-direction at the same pitch as the second finger portions 12a.

### Step of Connecting Solar Cells 1 Electrically Using Wiring Member 2

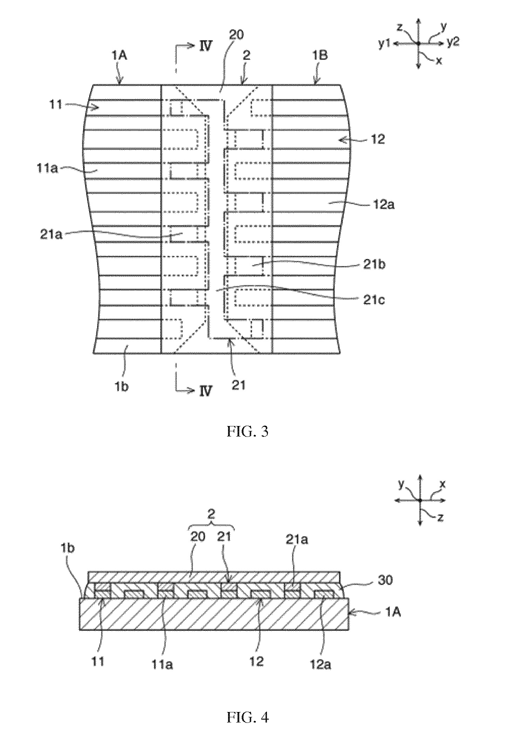

Next, a plurality of solar cells 1 is connected electrically using a wiring member 2 to produce a solar cell string having a plurality of solar cells 1 connected electrically by a wiring member 2. Specifically, as shown in FIG. 3, the wiring 21 of the wiring member 2 is connected electrically to the first finger portions 11a of the first electrode 11 in one solar cell (the first solar cell) 1A and the second finger portions 12a of the second electrode 12 of another solar cell (the second solar cell) 1B (connection step). This step is repeated to produce a solar cell string.

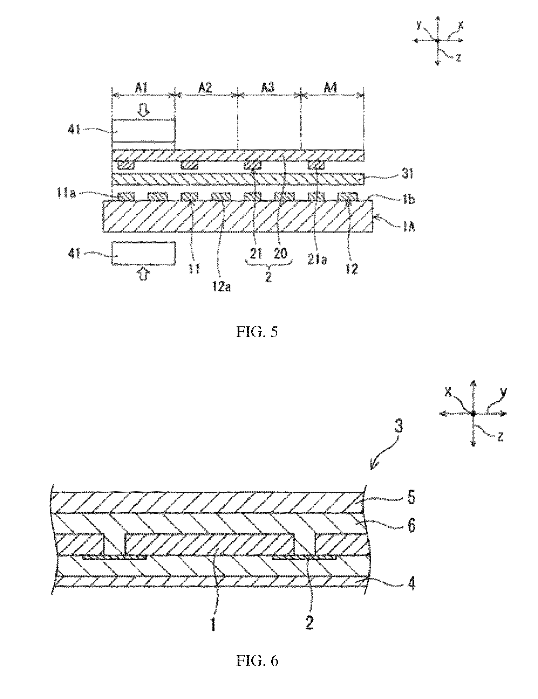

More specifically, as shown in FIG. 5, resin adhesive 31 is arranged between the wiring member 2 and solar cell 1A, heat and relative pressure are applied, and the resin adhesive 31 is thermocured to bond the wiring member 2 to the solar cell 1A and electrically connect the first linear portions 21a of the wiring member 2 to the first finger portions 11a of the solar cell 1A. Similarly, resin adhesive 31 is arranged between the wiring member 2 and solar cell 1B, heat and relative pressure are applied, and the resin adhesive 31 is thermocured to bond the wiring member 2 to the solar cell 1B and electrically connect the second linear portions 21b of the wiring member 2 to the second finger portions 12b of the solar cell 1B. When these steps have been performed, the solar cells 1A, 1B are bonded to the wiring member 2 via an adhesive layer 30 including the cured resin adhesive 31.

The resin adhesive 31 has insulating or conductive properties. Preferably, the main component of the resin adhesive 31 is an insulating resin, and the resin adhesive contains a conductive member inside. When a resin adhesive 31 not containing a conductive member is used, the wiring member 2 and solar cell 1A are preferably bonded such that the first linear portions 21a of the wiring member 2 and the first finger portions 11a of the solar cell 1A are in direct contact with each other. Similarly, the wiring member 2 and solar cell 1B are preferably bonded such that the second linear portions 21b of the wiring member 2 and the second finger portions 12a of the solar cell 1B are in direct contact with each other.

When a resin adhesive 31 containing a conductive member is used, the first finger portions 11a and the first linear portions 21a may be in direct electrical contact with each other or in indirect electrical contact via the conductive member. Similarly, the second portions 12a and the second linear portions 21b may be in direct electrical contact with each other or in indirect electrical contact via the conductive member.

When the resin adhesive 31 contains a conductive member, the size and concentration of the conductive member is adjusted so that undesired electrical contact does not occur via the conductive member. In other words, it is adjusted so that electrical contact does not occur between the first finger portions 11a and the second finger portions 12a via the conductive member, electrical contact does not occur between the first linear portions 21a and the second finger portions 12a via the conductive member, and electrical contact does not occur between the second linear portions 21b and the first finger portions 11a via the conductive member. When the resin adhesive 31 contains a conductive member, the conductive member is preferably an anisotropically conductive film or a resin adhesive with anisotropic conductive properties such as an anisotropically conductive paste.

In the connection step, as shown in FIG. 5, heat and pressure are applied to the wiring member 2 and the solar cell 1A separately in each of a plurality of areas A1-A4 arranged in the x-direction, or the second direction. Specifically, in the connection step, there is a step in which heat and pressure is applied to one of the areas A1-A4 using a heated bonding tool 41, and a step in which the bonding tool 41 is moved in the x-direction. In the connection step, these steps are repeated. The heat and pressure step is performed in the same manner between the wiring member 2 and solar cell 1B. There is actually a pair of bonding tools 41 above and below the solar cell.

More specifically the bonding tool 41 has a width that spans at least one first finger portion 11a and one second finger portion 12a (lengthwise in the x-direction). As seen in FIG. 3, the bonding tool 41 has a length which is at least approximately the same as that of the wiring member 2 (lengthwise in the y-direction).

First, as shown in FIG. 3, a first solar cell 1A and a second solar cell 1B are arranged adjacent to each other. Next, a resin adhesive 31 is interposed, and a wiring member 20 is arranged so as to span a side edge of the first solar cell 1A and a side edge of the second solar cell 1B. Then, heat and pressure are applied to area A1 using a heated bonding tool 41 to bond the wiring member 2 to the solar cells 1A, 1B in area A1. Simultaneously, the first linear portions 21a and the first finger portions 11a are connected electrically, and the second linear portions 22a and the second finger portion 12a are connected electrically in area A1. Afterwards, the heating tool 41 is moved to area A2 in the x-direction. Next, heat and pressure are applied to area A2 using a heated bonding tool 41 to bond the wiring member 2 to the solar cells 1A, 1B in area A2. Afterwards, the heating tool 41 is moved to area A3 in the x-direction. Next, heat and pressure are applied to area A3 using a heated bonding tool 41 to bond the wiring member 2 to the solar cells 1A, 1B in area A3. Afterwards, the heating tool 41 is moved to area A4 in the x-direction. Next, heat and pressure are applied to area A4 using a heated bonding tool 41 to bond the wiring member 2 to the solar cells 1A, 1B in area A4. Heat and pressure are applied four times to bond the wiring member 2 to the solar cells 1A, 1B. In addition, the first linear portions 21a and the first finger portions 11a are connected electrically, and the second linear portions 22a and the second finger portion 12a are connected electrically.

### Sealing Step

Next, the solar cell string is sealed between a first protecting member 4 and a second protecting member 5 using a bonding layer 6. For example, a resin sheet constituting the light-receiving side of the bonding layer 6 is arranged on the second protecting member 5. The solar cell string is then arranged on the resin sheet. A resin sheet constituting the back side of the bonding layer 6 is arranged thereon, and then the first protecting member 4 is arranged on top. These are laminated under heat and pressure in a reduced-pressure atmosphere to complete the solar module 3 shown in FIG. 6.

The second protecting member 5 can be made of a translucent member such as translucent glass or plastic. Light is incident on the solar module 3 from the side with the second protecting member 5.

The first protecting member 4 can be a weather-resistant member made of translucent glass or plastic, resin film, or resin film containing an interposed layer of metal foil.

The bonding layer 6 can be made of a resin such as an ethylene-vinylacetate (EVA) copolymer or polyvinyl butyral (PVB). The bonding layer 6 has translucent properties.

In the solar module 3, a terminal box may be arranged on the first protecting member 4 to extract electrical power generated by the solar cells 1. In addition, a metal or resin frame may be provided on the peripheral edges of the solar module 3.

From a manufacturing standpoint, it would be easier to apply heat and pressure to the wiring member and solar cells all at once. However, the wiring member and the solar cells have different thermal expansion coefficients. Usually, the thermal expansion coefficient of the wiring member is higher than that of the solar cells. Therefore, when heat and pressure are applied to the wiring member and the solar cells all at once, the wiring member expands more than the solar cells. As a result, the wiring in the wiring member and the electrodes in the solar cells become misaligned, and the wiring and electrodes are often not connected very well electrically.

In the present embodiment, heat and pressure are applied to the wiring member 2 and the solar cells 1A, 1B in the connection step separately in each of a plurality of areas A1-A4 in the x-direction or second direction. As compared to when heat and pressure are applied all at once to each of the areas A1-A4, in the connection step, the difference in the amount of thermal expansion by the wiring member 2 and the amount of thermal expansion by the solar cells 1A, 1B is small because the area of the wiring member 2 and the solar cells 1A, 1B heated all at once is small. Thus any misalignment between the wiring 21 in the wiring member 2 and the electrodes 11, 12 in the solar cells 1A, 1B can be suppressed. As a result, the wiring 21 and the electrodes 11, 12 are connected electrically in an advantageous manner. Therefore, a solar module 3 with improved reliability and output characteristics can be manufactured.

Because the difference in the amount of thermal expansion by the wiring member 2 and the amount of thermal expansion by the solar cells 1A, 1B in the connection step is small, the residual stress generated in the wiring member 2 and the solar cells 1A, 1B can also be reduced. This can suppress peeling of the wiring member 2 from the solar cells 1A, 1B and warping of the solar cells 1A, 1B.

In particular, when the wiring member 2 has a wiring member main body 20 made of resin, the thermal expansion coefficient of the wiring member 2 is greater relative to the solar cells 1. Therefore, misalignment of the electrodes and wiring is more likely to occur. Peeling of the wiring member 2 and warping of the solar cells 1 are also more likely to occur. Thus, it is especially advantageous in these circumstances to apply heat and pressure separately to each of a plurality of areas A1-A4.

The following is an explanation of another example of a preferred embodiment of the present invention. In the following explanation, members having functions that are substantially similar to those in the first embodiment are denoted by the same reference numbers and further explanation of these members has been omitted.

### 2nd Embodiment

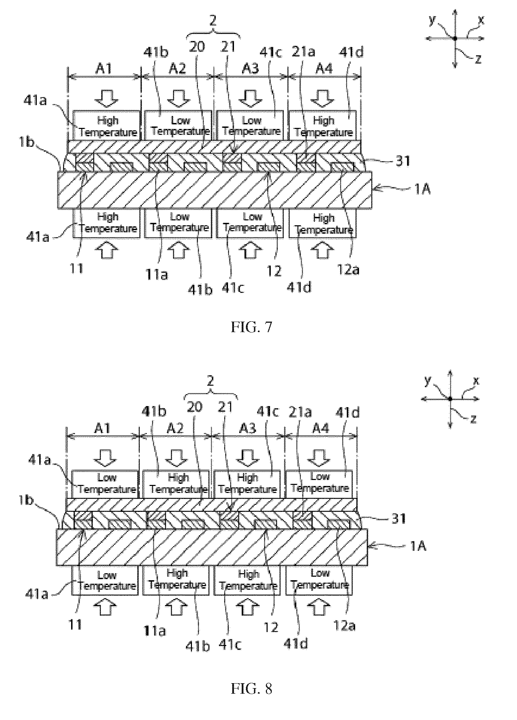

In the explanation of the first embodiment, the connection step was performed using a single pair of bonding tools 41. In the second embodiment, as shown in FIG. 7 and FIG. 8, the connection step is performed using several pairs of bonding tools 41a-41d. More specifically, in the connection step, there is a first connection step in which a pair of bonding tools 41 a-41 d provided in each of the areas A1-A4 is used to apply pressure to the wiring member 2 and the solar cells 1A, 1B while the temperature is raised in at least one of the pairs of bonding tools 41 a-41 d above the curing temperature at which the resin adhesive 31 is cured, and a second connection step in which the temperature is raised above the curing temperature in at least one of the remaining pairs of bonding tools 41a-41d after the first connection step. In each of the first and second connection steps, the temperature of the bonding tools other than those which have been raised above the curing temperature is preferably maintained at a temperature below the curing temperature.

More specifically, in the present embodiment, as shown in FIG. 7, pressure is first applied to the wiring member 2 and the solar cells 1A, 1B using the plurality of bonding tools 41a-41d provided in each of the areas A1-A4. In this state, the temperature of the bonding tools 4 1 a, 4 1 d positioned on both ends in the x-direction is raised above the curing temperature. In this way, the resin adhesive 31 is cured and the wiring member 2 is bonded to the solar cells 1A, 1B in areas A1 and A4. In this step, the temperature of bonding tools 41b and 41c are maintained at a temperature below the curing temperature.

Next, as shown in FIG. 8, while maintaining a state of pressure, the temperature of the bonding tools 41b, 41c positioned in the center in the x-direction is raised above the curing temperature. In this way, the resin adhesive 31 is cured and the wiring member 2 is bonded to the solar cells 1A, 1B in areas A2 and A3. In this step, the temperature of bonding tools 41a and 41d are maintained at a temperature below the curing temperature.

The effects are similar to those of the first embodiment even when the connection steps are performed in this way.

The present invention includes many embodiments not described herein. For example, either one of the first and second electrodes may have a busbar portion to which the finger portions are connected electrically.

In the explanation of the examples in the first and second embodiments, the solar cells were divided into four areas, and heat and pressure were applied to each of the areas. However, the present invention is not restricted to this number of areas. In other words, the present invention is not restricted to a certain number of applications of heat and pressure. For example, heat and pressure may be applied two separate times. Alternatively, heat and pressure may be applied to each area in which finger portions have been provided.

In the explanation of the example in the second embodiment, heat and pressure were applied to the central areas A2, A3 in the second direction (x-direction) after heat and pressure were applied to the areas A1, A4 on both ends in the second direction (x-direction). However, heat and pressure may be applied in the x-direction to area A1, area A2, area A3 and area A4 in sequential order. Alternatively, heat and pressure may be applied simultaneously to areas A3 and A4 after heat and pressure has been applied simultaneously to areas A1 and A2.

The present invention includes many other embodiments not described herein. Therefore, the technical scope of the present invention is defined solely by the items of the invention specified in the claims pertinent to the above explanation.

### Key to the Drawings

1, 1A, 1B: Solar cell
2: Wiring member
3: Solar module
4: 1 st protecting member
5: 2nd protecting member
6: Bonding layer
11: 1 st electrode
12: 2nd electrode
11a: 1 st finger portion
12a: 2nd finger portion
20: Wiring member main body
21: Wiring
21a: 1 st linear portion
21b: 2nd linear portion
21c: Connecting portion
30: Adhesive layer
31: Resin adhesive
41, 41a∼41d: Bonding tool
A1∼A4: Areas

## Claims

1. A method for manufacturing a solar module comprising a first connection step for electrically connecting a wiring member to a first electrode arranged on the back surface of a first solar cell,
the first connection step including a step of arranging the wiring member on the first electrode with a resin adhesive interposed therebetween, and a step of heating the wiring member while applying relative pressure on the first electrode side,
the heating step being performed separately in a plurality of areas.

2. The method for manufacturing a solar module according to claim 1, wherein the first electrode has a plurality of first finger portions extending in a first direction and being arranged at intervals in a second direction intersecting the first direction,
the wiring member having a length covering all of the plurality of first finger portions in the second direction, and
the heating step in the first connection step being performed separately in a plurality of areas divided in the second direction.

3. The method for manufacturing a solar module according to claim 2, wherein the wiring member has a wiring member main body made of resin, and first wiring provided on the wiring member main body and connected electrically to the first finger portions.

4. The method for manufacturing a solar module according to any one of claims 1 through 3, wherein a step of applying heat and pressure to one of the plurality of areas using a bonding tool, and a step of moving the bonding tool are performed repeatedly in the first connection step.

5. The method for manufacturing a solar module according to any one of claims 1 through 3, wherein the first connection step includes:
a first connection step for raising the temperature of at least one of a plurality of bonding tools above a curing temperature to cure the resin adhesive when relative pressure has been applied to the wiring member on the first electrode side using a plurality of bonding tools provided in each of the plurality of areas,
and a second connection step for raising the temperature of at least one of the remaining bonding tools above the curing temperature after the first connection step.

6. The method for manufacturing a solar module according to claim 5, wherein the remaining bonding tools are maintained at a temperature lower than the curing temperature in the first connection step,
and the bonding tools, except for at least one of the remaining bonding tools which is raised above the curing temperature, are maintained at a temperature lower than the curing temperature in the second connection step.

7. The method for manufacturing a solar module according to any one of claims 1 through 6 further comprising a second connection step for electrically connecting a wiring member to a second electrode arranged on the back surface of a second solar cell adjacent to the first solar cell,
the second connection step including a step of arranging the wiring member on the second electrode with a resin adhesive interposed therebetween, and a step of heating the wiring member while applying relative pressure on the second electrode side,
the heating step in the second connection step being performed separately in a plurality of areas.

8. The method for manufacturing a solar module according to claim 7, wherein the second electrode has a plurality of second finger portions extending in a first direction and being arranged at intervals in a second direction intersecting the first direction,
the wiring member having a length covering all of the plurality of second finger portions in the second direction, and
the heating step in the second connection step being performed separately in a plurality of areas divided in the second direction.

9. The method for manufacturing a solar module according to claim 8, wherein the wiring member has a wiring member main body made of resin, second wiring provided on the wiring member main body and connected electrically to the second finger portions, and a connecting portion for the first wiring and the second wiring.
